# EUROPÄISCHE PATENTSCHRIFT

(11) **EP 2 577 869 B1**
(45) Veröffentlichungstag und Bekanntmachung des Hinweises auf die Patenterteilung: **18.09.2013**
(21) Anmeldenummer: 11728170.9
(22) Anmeldetag: 26.05.2011
(51) Int. Cl.: H03K 17/96

(54) **VERFAHREN UND VORRICHTUNG ZUR DURCHFÜHRUNG EINES SCHALTVORGANGS**
METHOD AND APPARATUS FOR CARRYING OUT A SWITCHING PROCESS
PROCÉDÉ ET DISPOSITIF PERMETTANT L'EXÉCUTION D'UN PROCESSUS DE COMMUTATION

(30) Priorität: 31.05.2010 AT 8802010
(43) Veröffentlichungstag der Anmeldung: 10.04.2013
(73) Patentinhaber: Fronius International GmbH, 4643 Pettenbach (AT)
(72) Erfinder: FASTHUBER, Christian, 4600 Wels (AT); SCHUSTER, Florian, 4050 Traun (AT); ORTNER, Gerald, 4040 Linz/Donau (AT); SANDBERGER, Michael, 4020 Linz (AT)
(74) Vertreter: Heger, Georg
(86) Internationale Anmeldenummer: PCT/AT2011/000241
(87) Internationale Veröffentlichungsnummer: WO 2011/150437

(56) Entgegenhaltungen:
- EP-A1- 0 809 371
- US-A1- 2003 020 004
- US-A1- 2004 217 267

## Beschreibung

Die Erfindung betrifft ein Verfahren und eine Vorrichtung zur Durchführung eines Schaltvorgangs mit Hilfe eines Bedienelements.

Üblicherweise werden Schaltvorgänge mit mechanischen Bedienelementen, wie zum Beispiel Tastern oder Schaltern durchgeführt. Diese mechanischen Komponenten unterliegen einem gewissen Verschleiß und benötigen darüber hinaus gewissen Platz auf der jeweiligen Einrichtung, der nicht immer zur Verfügung steht.

Die US 2003/020004 A1 beschreibt eine optoelektronische Schalteinrichtung bestehend aus einem licht-emittierenden Sendeelement und einem Empfangselement in Form eines an sich bekannten Reflexlichtschrankens.

Die EP 0 809 371 A1 zeigt ebenfalls eine eigene optoelektronische Schaltung zur Durchführung des Schaltvorganges umfassend eine Leuchtdiode und ein Empfangsgerät.Auch die US 2004/217267 A1 umfasst sowohl licht-emittierende als auch licht-detektierende Sensorelemente, welche zur Durchführung des Schaltvorganges verwendet werden.

Die Aufgabe der vorliegenden Erfindung besteht daher in der Schaffung eines oben genannten Verfahrens und einer oben genannten Vorrichtung zur Durchführung eines Schaltvorgangs mit Hilfe eines Bedienelements, durch welche diese Nachteile vermieden werden können.

Gelöst wird die Aufgabe in verfahrensmäßiger Hinsicht dadurch, dass als Bedienelement zumindest eine Anzeige, beispielsweise eines Betriebszustands eines Geräts, vorgesehene Leuchtdiode in einem abgeschalteten Zustand und eine Einrichtung zur Messung der Spannung an der zumindest einen Leuchtdiode verwendet wird, die durch das Umgebungslicht hervorgerufene Spannung an der zumindest einen Leuchtdiode im abgeschalteten Zustand gemessen wird, und der Schaltvorgang durchgeführt wird, wenn in Folge einer Abdunkelung der zumindest einen Leuchtdiode durch einen Finger eines Bedieners auf Grund einer Verringerung des Umgebungslichts die gemessene Spannung über eine vorgegebene Zeitdauer unter einen vorgegebenen ersten Schwellwert sinkt. Gemäß diesem Verfahren wird daher eine Leuchtdiode, welche beispielsweise zur Anzeige eines Betriebszustands eines Geräts vorgesehen ist, als Schaltelement eingesetzt. Dementsprechend ist kein eigenes Schaltelement zur Durchführung des Schaltvorgangs erforderlich, sodass Platz und Kosten gespart werden können. Auch tritt bei Leuchtdioden im Gegensatz zu mechanischen Schaltelementen kein Verschleiß auf, wodurch Fehlfunktionen verhindert werden können. Ebenso ist durch die Leuchtdioden eine galvanische Trennung gegeben, wodurch die Wahrscheinlichkeit des Auftretens von Verbindungen zu Spannungsführenden Teilen reduziert werden kann. Auch werden Schaltvorgänge durch Umwelteinflüsse, wie Verschmutzung, Feuchtigkeit, Spritzwasser, usw. kaum beeinträchtigt. Somit können Geräte, wie zum Beispiel Wechselrichter, Schweißgeräte, Schneidgeräte, Batterieladegeräte, Brennstoffzellen, oder dergleichen ohne mechanische Bedienelemente über allenfalls bereits vorhandene Leuchtdioden bedient werden oder zumindest bestimmte Schaltvorgänge an diesen Geräten durchgeführt werden. Selbstverständlich können auch mehrere Schaltvorgänge hintereinander durchgeführt und damit bestimmte Vorgänge ausgelöst oder Einstellungen am jeweiligen Gerät vorgenommen werden. Die Spannungsmessung erfolgt kontinuierlich oder in periodischen Abständen mit einer entsprechend geeignet gewählten Abtastfrequenz.

Um Fehlschaltungen durch sich verändernde Verhältnisse des Umgebungslichts zu vermeiden, ist vorgesehen, dass der Schaltvorgang durchgeführt wird, wenn zusätzlich die gemessene Spannung an der zumindest einen Leuchtdiode nach dem Absinken unter den vorgegebenen ersten Schwellwert über eine definierte Zeitdauer über einen vorgegebenen zweiten, oder dem ersten Schwellwert liegenden Schwellwert steigt. Dabei ist für die Einleitung eines Schaltvorgangs zwingend erforderlich, dass der Benutzer den Finger wieder aktiv von der zumindest einen Leuchtdiode nimmt, sodass nach dem Absinken der Spannung wieder ein Spannungsanstieg gemessen werden kann. Die Bedingung wird noch an eine vorgegebene Zeitdauer geknüpft, während welcher die gemessene Spannung den vorgegebenen ersten Schwellwert übersteigen muss, sodass ein Schaltvorgang durchgeführt wird.

Wenn der zweite Schwellwert der gemessenen Spannung an der zumindest einen Leuchtdiode in Abhängigkeit der Stärke des Umgebungslichts geändert wird, kann eine Einstellung der Empfindlichkeit vorgenommen werden.

Die zumindest eine Leuchtdiode kann periodisch abgeschaltet, und jeweils mit der Abschaltung die Messung der Spannung an der zumindest einen Leuchtdiode im abgeschalteten Zustand gestartet werden. Dadurch kann auch bei einer für bestimmte Signalisierungen eingesetzten Leuchtdiode in den periodisch wiederkehrenden kurzen Zeitspannen ein Schaltvorgang vorgenommen werden. Diese Zeitspannen können so kurz gewählt werden, dass sie für das menschliche Auge nicht erkennbar sind.

Gelöst wird die erfindungsgemäße Aufgabe in verfahrensmäßiger Hinsicht auch dadurch, dass als Bedienelement zumindest eine als Anzeige, beispielsweise eines Betriebszustands eines Geräts, vorgesehene Leuchtdiode in einem abgeschalteten Zustand und eine Einrichtung zur Messung der Spannung an der zumindest einen Leuchtdiode verwendet wird, die Spannung an der zumindest einen Leuchtdiode im abgeschalteten Zustand gemessen wird, die zumindest eine Leuchtdiode während des abgeschalteten Zustands mit zumindest einer Referenzleuchtdiode bestrahlt wird, um eine Unabhängigkeit vom Umgebungslicht zu erzielen, die durch das Licht der Referenzleuchtdiode hervorgerufene Spannung an der zumindest einen Leuchtdiode im abgeschalteten und durch die zumindest eine Referenzleuchtdiode bestrahlten Zustand gemessen wird, und danach die zumindest eine Referenzleuchtdiode abgeschaltet wird, die Spannung an der zumindest einen Leuchtdiode im abgeschalteten Zustand der zumindest einen Referenzleuchtdiode gemessen wird, und der Schaltvorgang durchgeführt wird, wenn in Folge einer Abdunkelung der zumindest einen Leuchtdiode durch einen Finger eines Bedieners die gemessene Spannung über eine vorgegebene Zeitdauer unter einen vorgegebenen ersten Schwellwert sinkt. Bei dieser zweiten Ausführungsform der Erfindung wird durch die zumindest eine Referenzleuchtdiode eine definierte Hintergrundbeleuchtung geschaffen und ein sicherer Umschaltvorgang, insbesondere bei geringem Umgebungslicht bzw. eine Unabhängigkeit vom Umgebungslicht erzielt.

Die zumindest eine Referenzleuchtdiode kann nach einer definierten Zeitdauer wieder eingeschaltet werden, so dass ein weiterer Schaltvorgang durchgeführt werden kann.

Bei der zweiten Ausführungsform kann als zusätzliche Bedingung für die Durchführung eines Schaltvorganges eingeführt werden, dass die gemessene Spannung innerhalb eines zwischen einem zweiten, ober dem ersten Schwellwert liegenden Schwellwert und dem ersten Schwellwert vorgegebenen Auswertebereichs liegt. Dadurch kann eine erhöhte Sicherheit beim Schalten erzielt werden.

Vorteilhafter Weise wird die Durchführung des Schaltvorgangs signalisiert. Dieses Feedback für den Benutzer kann optisch, akustisch oder mechanisch, beispielsweise durch ein Vibrationselement, erfolgen.

Gelöst wird die erfindungsgemäße Aufgabe auch durch eine oben genannte Vorrichtung, wobei das Bedienelement durch zumindest eine als Anzeige, beispielsweise eines Betriebszustandes eines Geräts, vorgesehene Leuchtdiode gebildet ist, eine Einrichtung zur Messung der durch das Umgebungslicht hervorgerufenen Spannung an der zumindest einen Leuchtdiode im abgeschalteten Zustand vorgesehen ist, sodass der Schaltvorgang durchführbar ist, wenn die gemessene Spannung in Folge einer Abdunkelung der zumindest einen Leuchtdiode durch einen Finger eines Bedieners auf Grund einer Verringerung des Umgebungslichts über eine vorgegebene Zeitdauer unter einen vorgegebenen ersten Schwellwert sinkt. Eine derartige Vorrichtung ist relativ einfach, platzsparend und kostengünstig herstellbar. Durch die Verwendung mehrerer in Serie geschalteten Leuchtdioden als Bedienelement kann die Amplitude der durch den Fotoeffekt hervorgerufenen Spannung bzw. der Spannungshub erhöht und somit die Auflösung der Messung verbessert werden.

Die Messeinrichtung ist in vorteilhafter Weise durch einen entsprechend empfindlichen Messverstärker gebildet.

Vorteile ergeben sich weiters, wenn der zumindest einen Leuchtdiode ein Widerstand parallel geschaltet ist und Anschlüsse der zumindest einen Leuchtdiode, welche mit der Einrichtung zur Messung der Spannung verbunden sind, über jeweils einen Kondensator mit Erde verbunden sind.

Zur Erzeugung einer definierten Hintergrundbeleuchtung kann zumindest eine Referenzleuchtdiode zur Erzeugung eines definierten Umgebungslichts vorgesehen sein, welche die zumindest eine Leuchtdiode während des Messvorgangs für die Durchführung des Schaltvorgangs entsprechend beleuchtet.

Zur Vermeidung ungewollter Fremdlichteinstrahlung ist um die zumindest eine Leuchtdiode und allenfalls zumindest eine Referenzleuchtdiode eine teilweise lichtundurchlässige Abdeckung angebracht.

Die vorliegende Erfindung wird anhand der beigefügten, schematischen Zeichnungen näher erläutert.

Darin zeigen:
Fig. 1 eine schematische Übersichtsdarstellung eines Wechselrichters einer Photovoltaikanlage;
Fig. 2 einen Aufbau einer ersten Variante einer Vorrichtung zur Durchführung eines Schaltvorgangs;
Fig. 3 den Spannungsverlauf an der Leuchtdiode der ersten Variante während eines Schaltvorgangs;
Fig. 4 einen Aufbau einer zweiten Variante einer Vorrichtung zur Durchführung eines Schaltvorgangs;
Fig. 5 eine schematische Schnittdarstellung der Anordnung der Leuchtdiode und einer Referenzleuchtdiode hinter einer Abdeckung;
Fig. 6 eine schematische Draufsicht auf die Anordnung gemäß Fig. 5; und
Fig. 7 den Spannungsverlauf an der Leuchtdiode der zweiten Variante während eines Schaltvorgangs.

Einführend wird festgehalten, dass gleiche Teile des Ausführungsbeispiels mit gleichen Bezugszeichen versehen werden.

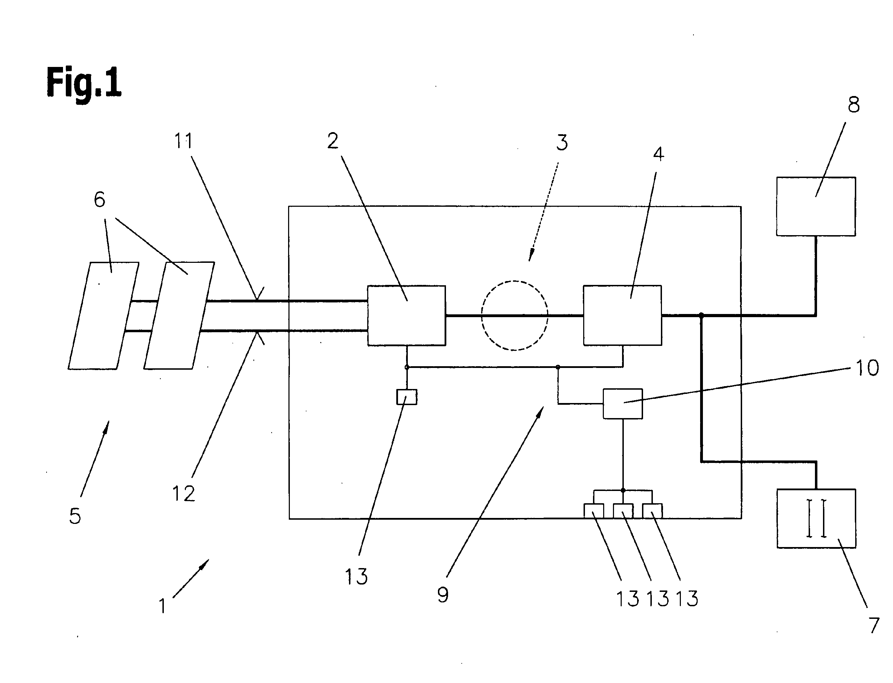

In Fig. 1 ist ein Aufbau eines bekannten Wechselrichters 1, im Detail eines HF-Wechselrichters, einer Photovoltaikanlage (PV-Anlage) dargestellt. Da die einzelnen Komponenten bzw. Baugruppen und Funktionen von Wechselrichtern 1 bereits aus dem Stand der Technik bekannt sind, wird auf diese nachstehend nicht im Detail eingegangen.

Der Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 5 angeschlossen, welche bevorzugt aus einem oder mehreren parallel und/oder seriell zueinander geschalteten Solarmodulen 6 gebildet werden. Der Ausgang des Wechselrichters 1 bzw. des Ausgangs-D-C-AC-Wandlers 4 kann mit einem Versorgungsnetz 7, wie ein öffentliches oder privates Wechselspannungsnetz oder ein Mehr-Phasennetz, und/oder mit zumindest einem elektrischen Verbraucher 8, welcher eine Last darstellt, verbunden sein. Beispielsweise wird ein Verbraucher 8 durch einen Motor, Kühlschrank, Funkgerät usw. gebildet. Ebenso kann der Verbraucher 8 auch eine Hausversorgung darstellen. Die einzelnen Komponenten des Wechselrichters 1, können über einen Datenbus 9 mit einer Steuervorrichtung 10 verbunden sein.

Bevorzugt dient ein derartiger Wechselrichter 1 als sogenannter netzgekoppelter Wechselrichter 1, dessen Energiemanagement daraufhin optimiert ist, dazu, möglichst viel Energie in das Versorgungsnetz 7 einzuspeisen. Wie aus dem Stand der Technik bekannt, werden die Verbraucher 8 über das Versorgungsnetz 7 versorgt. Selbstverständlich können auch mehrere parallel geschaltete Wechselrichter 1 eingesetzt werden, wodurch mehr Energie zum Betrieb der Verbraucher 8 bereitgestellt werden kann. Die Energie wird von der Energiequelle 5 in Form einer Gleichspannung geliefert und über zwei Anschlussleitungen 11, 12 dem Wechselrichter 1 zugeführt.

Die Steuervorrichtung 10 des Wechselrichters 1 ist beispielsweise durch einen Mikroprozessor, Mikrocontroller oder Rechner gebildet. Über die Steuervorrichtung 10 kann eine entsprechende Steuerung bzw. Regelung der einzelnen Komponenten des Wechselrichters 1, wie dem Eingangs-DC-DC-Wandler 2 oder dem Ausgangs-DC-AC-Wandler 4, insbesondere der darin angeordneten Schaltelemente, vorgenommen werden. In der Steuervorrichtung 10 sind hierzu die einzelnen Regel- bzw. Steuerabläufe durch entsprechende Software-Programme und/oder Daten bzw. Kennlinien gespeichert.

Des Weiteren sind mit der Steuervorrichtung 10 Bedienelemente 13 verbunden, durch welche der Benutzer den Wechselrichter 1 beispielsweise konfigurieren und/oder Betriebszustände oder Parameter anzeigen - beispielsweise mittels Leuchtdioden - und einstellen kann. Die Bedienelemente 13 sind dabei beispielsweise über den Datenbus 9 oder direkt mit der Steuervorrichtung 10 verbunden. Derartige Bedienelemente 13 sind beispielsweise an einer Front des Wechselrichters 1 angeordnet, sodass eine Bedienung von außen möglich ist. Ebenso können die Bedienelemente 13 auch direkt an Baugruppen und/oder Modulen innerhalb des Wechselrichters 1 angeordnet sein.

Erfindungsgemäß ist nun vorgesehen, dass die Bedienelemente 13 jeweils durch zumindest eine Leuchtdiode 14 gebildet werden. Zur Betätigung der Bedienelemente 13 wird die bei der abgeschalteten Leuchtdiode 14 anliegende Spannung U gemessen. Diese Spannung U ist von der Umgebungshelligkeit abhängig, sodass eine durch den Fotoeffekt hervorgerufene Spannung an der Leuchtdiode 14 gemessen wird. Entsprechend wird bei einer Änderung der Umgebungshelligkeit auch die Spannung U verändert. Bei einem bestimmten Verlauf der Spannung U wird ein Schaltvorgang ausgelöst.

Die Umgebungshelligkeit wird bevorzugt derart verändert, indem ein Bediener mit einem Finger die Leuchtdiode 14 abdunkelt, beispielsweise durch Abdecken. Im Wesentlichen entspricht dies der Betätigung eines Schaltelements und/oder einem Tastendruck, wobei der Schaltvorgang aufgrund der Änderung der Spannung U an der zumindest einen Leuchtdiode 14 bedingt durch die Änderung der einfallenden Umgebungshelligkeit ausgelöst wird. Dazu wird die Spannungsänderung mit einem vorgegebenen zeitlichen Verlauf verglichen, sodass ausschließlich bewusst hervorgerufene Schaltvorgänge ausgelöst werden.

Beispielhaft wird dieses Prinzip im Folgenden anhand zweier unterschiedlicher Varianten detailliert beschrieben.

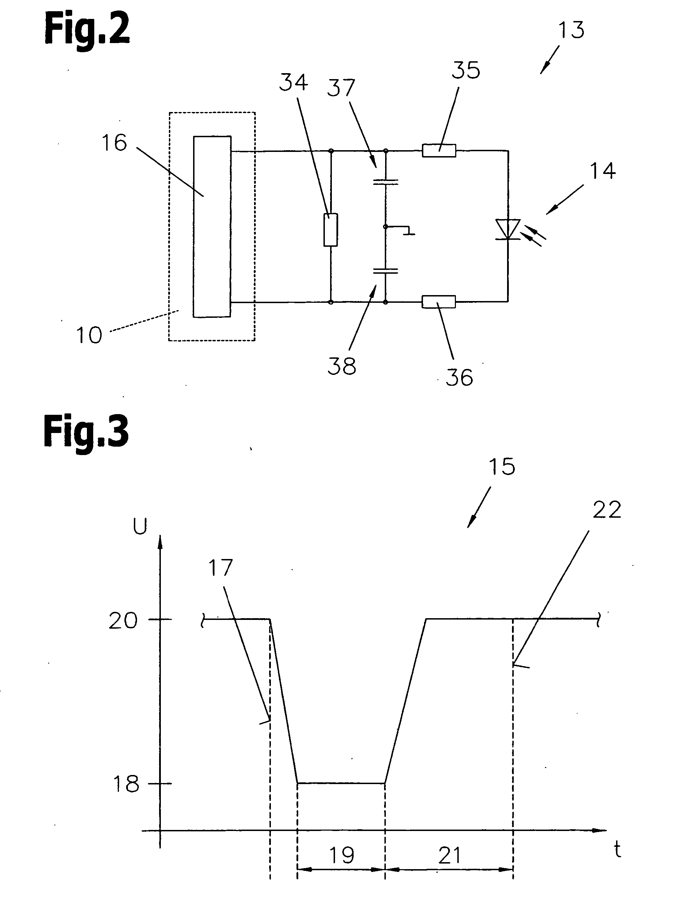

Bei der ersten Variante gemäß den Fig. 2 und 3 dient eine Leuchtdiode 14 eines Datenkommunikationsmoduls eines Wechselrichters 1 einer Photovoltaikanlage als Anzeige des Betriebszustandes. Die Leuchtdiode 14 kann an einer Vorderseite des Gehäuses des Wechselrichters 1 oder in einem Teil einer Bedienfront des Wechselrichters 1 angeordnet sein. Die Leuchtdiode 14 leuchtet bei Normalbetrieb und ist im Fehlerfall abgeschaltet. Beispielsweise wird das Datenkommunikationsmodul durch eine integrierte Überstrombegrenzung abgeschaltet. Somit ist zumindest der Steuervorrichtung 10 des Wechselrichters 1 der Zustand der Leuchtdiode 14 bekannt. Nachdem der Fehlerfall von einem Bediener überprüft und/oder behoben wurde, muss dieser das Datenkommunikationsmodul wieder in Betrieb nehmen. Dies erfolgt anhand des erfindungsgemäßen Prinzips, wobei die Leuchtdiode 14 als Bedienelement 13 dient. Dazu wird eine gewisse Umgebungshelligkeit vorausgesetzt, welche beispielsweise durch Tageslicht oder durch eine entsprechende Beleuchtung gegeben ist, was im Fall der Anwesenheit des Benutzers im Fehlerfall automatisch gegeben ist.

Des Weiteren wird eine Spannung 15 an der abgeschalteten Leuchtdiode 14 kontinuierlich oder in periodischen Zeitabständen, beispielsweise im ms-Bereich, gemessen. Dies erfolgt bevorzugt über einen Messverstärker 16, wie einem Differenzeingang eines Mikrokontrollers, wobei die Spannung U entsprechend verstärkt wird. Bevorzugt ist der Messverstärker 16 in der Steuervorrichtung 10 integriert. Soll nun das Datenkommunikationsmodul wieder eingeschaltet werden, verdunkelt der Bediener die Leuchtdiode 14, indem er seinen Finger über die Leuchtdiode 14 legt und dadurch die Leuchtdiode 14 abdeckt. Demnach sinkt die gemessene Spannung 15, da sich die Umgebungshelligkeit verringert oder die Leuchtdiode 14 mit keiner Umgebungshelligkeit mehr beleuchtet wird. Die Abdunkelung erfolgt gemäß Fig. 3 zum Zeitpunkt 17. Der Schaltvorgang wird allerdings noch nicht ausgelöst, da zuerst der weitere Verlauf der Änderungen der Spannung 15 ausgewertet wird. Um einen Schaltvorgang auszulösen, muss die Spannung 15 auf einen vordefinierten ersten Schwellwert 18 absinken. Dieser erste Schwellwert 18 muss zumindest über eine definierte Zeitdauer 19 und/oder innerhalb eines definierten Zeitfensters 19 unterschritten werden. Es muss also die Leuchtdiode 14 zumindest diese definierte Zeitdauer 19 lang abgedunkelt werden. Sobald die definierte Zeitdauer 19, beispielsweise 400 ms, überschritten ist und der Finger von der Leuchtdiode 14 entfernt wird, steigt die Spannung 15 wieder auf den Wert vor der Abdunkelung. Dieser Wert wird als zweiter Schwellwert 20 bezeichnet. Wird dieser zweite Schwellwert 20 ebenso eine definierte Zeitdauer 21, beispielsweise ebenfalls 400 ms, überschritten, wird zum Zeitpunkt 22 ein Schaltvorgang durchgeführt. Die Schwellwerte 18 und 20 und die Dauer der Zeitdauer 19 und 21 können in einem Speicher des Wechselrichters 1 hinterlegt werden und die gemessenen Werte mit den gespeicherten Werten verglichen werden. Der Verlauf der gemessenen Spannung 15 muss also einen Abfall und einen Anstieg aufweisen, dass ein Schaltvorgang durchgeführt wird. Somit ist gewährleistet, dass nur bei einer bewusst hervorgerufenen Verdunkelung der Leuchtdiode 14 - wie durch Abdeckung mit dem Finger, ein Schaltvorgang durchgeführt wird. Der erfolgreich durchgeführte Schaltvorgang wird dem Benutzer beispielsweise derart signalisiert, indem die Leuchtdiode 14 - mit welcher gemessen wurde - wieder eingeschaltet wird. Neben dieser sichtbaren Signalisierung ist auch eine akustische Signalisierung, eine mechanische Signalisierung durch Vibration und/oder dergleichen möglich.

Durch ein periodisches Ein- und Ausschalten der Leuchtdiode 14 können auch mehrere Schaltvorgänge hintereinander - beispielsweise für bestimmte Einstellungen - durchgeführt werden. Die Perioden sind dabei so gewählt, dass die Leuchtdiode 14 für den Benutzer als ständig eingeschaltet wirkt. Es werden also kurzfristige Dunkelphasen erzeugt, in denen das erfindungsgemäße Verfahren durchgeführt werden kann.

Die Spannungsänderung zwischen den Schwellwerten 18 und 20 ist von der Umgebungshelligkeit abhängig. Dementsprechend ist die Auswertung bei geringer Umgebungshelligkeit empfindlicher, da die Differenz zwischen den Schwellwerten 18 und 20 sinkt. Die bei abgeschalteter Leuchtdiode 14 gelieferte Spannung 15 hängt also von der Umgebungshelligkeit ab. Somit ändert sich der zweite Schwellwert 20 laufend mit der aktuellen Umgebungshelligkeit, sodass der zweite Schwellwert 20 periodisch neu abgespeichert werden sollte.

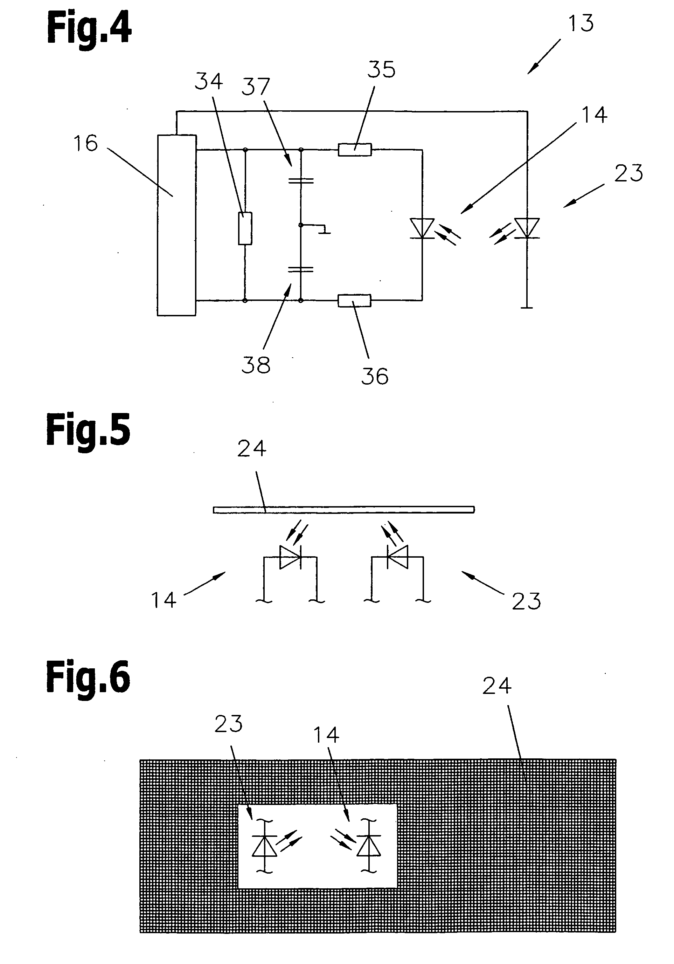

Um eine Unabhängigkeit des zweiten Schwellwerts 20 von der Umgebungshelligkeit zu erzielen, kann die Leuchtdiode 14 mit einer Referenzleuchtdiode 23 beleuchtet werden. Dies wird im Folgenden anhand einer zweiten Erfindungsvariante anhand der Fig. 4 bis 7 beschrieben. Hierzu sei noch erwähnt, dass lediglich die Unterschiede zur ersten Variante beschrieben werden, sodass auch Teile aus der Beschreibung der ersten Variante auf die zweite Variante übertragbar sind.

Bei dieser Variante werden die Lichtstrahlen der Referenzleuchtdiode 23 zur Detektierung eines Schaltvorgangs zur Leuchtdiode 14 reflektiert und/oder umgelenkt. Dazu sind beispielsweise sowohl die Leuchtdiode 14 als auch die Referenzleuchtdiode 23 im Wesentlichen nebeneinander in einem definierten Abstand unterhalb einer transparenten Abdeckung 24 positioniert, wie aus Fig. 5 ersichtlich. Die Abdeckung 24 kann durch eine Bedienfront des Wechselrichters 1 gebildet sein. Bei einer weiteren Ausführungsform (nicht dargestellt) beleuchtet beispielsweise die Referenzleuchtdiode 23 ein Trägermaterial mit integrierten Reflexionsschichten, sodass eine sehr flache Ausführung für ein Schaltelement möglich ist. Dementsprechend ist es nicht erforderlich, die Leuchtdiode 14 und die Referenzleuchtdiode 23 nebeneinander anzuordnen.

Der Bereich der Abdeckung 24 um die Leuchtdiode 14 und die Referenzleuchtdiode 23 ist lichtgeschützt ausgebildet, sodass seitlich kein Umgebungslicht eindringen kann, wie aus Fig. 6 ersichtlich ist. Somit ist gewährleistet, dass bei einer Abdunkelung mit dem Finger kein Umgebungslicht zur Leuchtdiode 14 gelangt und für den Benutzer ein Schaltelement und/oder Bedienelement 13 erkennbar ist. Das Bedienelement 13 ergibt sich demnach aus dem lichtdurchlässig ausgebildeten Bereich.

Wie bei der ersten Ausführungsvariante wird auch bei der zweiten Ausführungsform die Spannung 15 der Leuchtdiode 14 im Dunkelzustand gemessen. Im Gegensatz zur ersten Variante wird hier allerdings mit der Referenzleuchtdiode 23 eine konstante Helligkeit erzeugt und eine entsprechende Spannung 15 gemessen, sobald die Lichtstrahlen der Referenzleuchtdiode 23 zur Leuchtdiode 14 reflektiert und/oder umgelenkt werden. Die Umlenkung erfolgt über den Finger des Benutzers auf der Abdeckung 24. Somit wird bei einer Abdunkelung die Helligkeit der Referenzleuchtdiode 23 gemessen. Erfolgt keine Abdunkelung, wird die Umgebungshelligkeit gemessen.

Um jedoch zu verhindern, dass bei einer Umgebungshelligkeit - welche der Helligkeit gemäß der Referenzleuchtdiode 23 entspricht - ein Schaltvorgang durchgeführt wird, wird ein zweiter Schwellwert 25 und ein erster Schwellwert 26 der gemessenen Spannung 15 und zwischen den Schwellwerten 25 und 26 ein entsprechender Auswertebereich definiert. Selbstverständlich kann sich der Auswertebereich dynamisch an die äußeren Umgebungsbedingungen anpassen, sodass die Empfindlichkeit für die Durchführung eines Schaltvorgangs optimal auf die Anwendung abgestimmt ist.

Die Schwellwerte 25 und 26 liegen oberhalb und unterhalb der durch die Referenzleuchtdiode 23 definierten Helligkeit. Bei einer gemessenen Helligkeit innerhalb dem Auswertebereich erfolgt eine Auswertung der Spannung, bevor ein Schaltvorgang durchgeführt wird. Wird eine Helligkeit außerhalb des Auswertebereichs gemessen, werden keine weiteren Schritte eingeleitet. Somit kann ausschließlich mit gemessenen Spannungen U innerhalb des Auswertebereichs ein Schaltvorgang durchgeführt werden. Die Auswertung wird im Folgenden detailliert beschrieben.

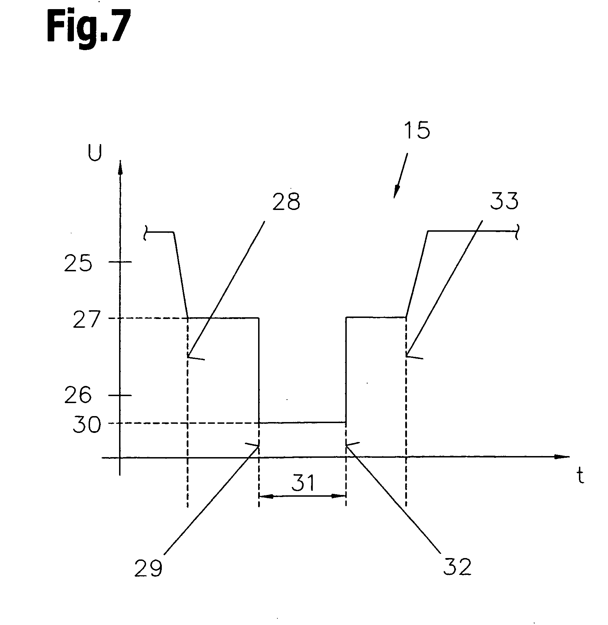

Die Referenzleuchtdiode 23 leuchtet im Wesentlichen ständig, sodass jederzeit ein Schaltvorgang durchführbar ist. Zur Auslösung eines Schaltvorgangs wird mit dem Finger die Leuchtdiode 14 und die Referenzleuchtdiode 23 entsprechend abgedunkelt, sodass die Lichtstrahlen der Referenzleuchtdiode 23 zur Leuchtdiode 14 reflektiert werden und keine Umgebungshelligkeit zur Leuchtdiode 14 gelangt. Somit wird von der Leuchtdiode 14 im ersten Schritt ein Spannungswert 27 ab dem Zeitpunkt 28 gemäß Fig. 7 für die Helligkeit gemessen, welcher im Auswertebereich liegt. Wie dargestellt, sinkt beispielsweise die Spannung nach der Abdunkelung und es wird der konstante Spannungswert 27 entsprechend der Helligkeit der Referenzleuchtdiode 23 gemessen. Damit ist eine Grundvoraussetzung zur Absicht, einen Schaltvorgang durchzuführen, gegeben. Unter dieser Grundvoraussetzung wird die Referenzleuchtdiode 23 zum Zeitpunkt 29 abgeschaltet und in einem zweiten Schritt erneut die Spannung an der Leuchtdiode 14 gemessen. Durch die Abdunkelung mit dem Finger gelangt daher im Wesentlichen kein Licht zur Leuchtdiode 14, sodass ein Spannungswert 30 unter dem ersten Schwellwert 26 gemessen wird. Wird nun dieser Spannungswert 30 über eine definierte Zeitdauer 31 gemessen und/oder liegt dieser innerhalb eines definierten Zeitfensters 31, wird der Schaltvorgang zum Zeitpunkt 32 durchgeführt.

Dementsprechend wird der Schaltvorgang auch durchgeführt, wenn mit dem Finger die Leuchtdiode 14 noch abgedunkelt ist. Wesentlich ist dabei, dass bei der Messung im zweiten Schritt ein geringerer Wert für die Spannung als bei der Messung im ersten Schritt gemessen wird. Mit dem Schaltvorgang wird die Referenzleuchtdiode 23 wieder eingeschaltet, sodass im Anschluss ein weiterer Schaltvorgang durchgeführt werden kann. Zum Zeitpunkt 33 wurde der Finger wieder entfernt, sodass wieder die Umgebungshelligkeit gemessen wird. Hierbei ist die Umgebungshelligkeit höher als die Helligkeit der Referenzleuchtdiode 23.

Durch die Messung gemäß dem zweiten Schritt wird ausgeschlossen, dass ein Schaltvorgang ohne Abdunkelung durch den Finger durchgeführt wird. Denn auch wenn im ersten Schritt aufgrund der Umgebungshelligkeit für die Spannung ein Wert innerhalb des Auswertefensters gemessen wird, verändert sich dieser Wert bei der Messung im zweiten Schritt nicht. Somit wird auch kein Schaltvorgang durchgeführt.

Durch das regelbare Schalten der Referenzleuchtdiode 23 kann eingestellt werden, in welchen zeitlichen Abständen ein Schaltvorgang durchgeführt werden kann. Entsprechend können somit die Schaltvorgänge sehr schnell hintereinander durchgeführt werden, sodass eine schnelle Bedienung auch bei mehreren Einstellmöglichkeiten durchführbar ist.

In den zwei Ausführungsvarianten ist jeweils die Durchführung eines Schaltvorgangs beschrieben. Selbstverständlich kann nach der Durchführung eines Schaltvorgangs ein weiterer Schaltvorgang durchgeführt werden.

Die Beschaltung der an einem Mikrokontroller angeschlossenen Leuchtdiode 14 für das erfindungsgemäße Prinzip gemäß den Fig. 2 und 4 erfolgt bevorzugt mit einem Parallelwiderstand 34, zwei Vorwiderstände 35, 36 und zwei Kondensatoren 37, 38. Bevorzugt verfügt der Mikrokontroller über eine interne Verstärkung, sodass die gemessene Spannung der abgeschalteten Leuchtdiode 14 auf den oberen Schwellwert 20 verstärkt werden kann. Damit die gemessene Spannung U nicht von Störungen beeinflusst wird, sind an zwei gegengleich gepolten Anschlüssen der zumindest einen Leuchtdiode 14 jeweils ein Kondensator 37, 38 angeschlossen, welche mit Erde verbunden sind. Die Dimensionierung der Kondensatoren 37, 38 ist dabei ein Kompromiss zwischen minimalen Störeinflüssen und der Geschwindigkeit der Auswertung. Um beides zu erreichen, wird der Leuchtdiode 14 der Widerstand 34 parallel geschaltet.

Selbstverständlich kann das anhand eines Wechselrichters 1 beschriebene erfindungsgemäße Prinzip auch auf andere Geräte übertragen werden. So kann das Bedienelement ohne mechanische Schalter beispielsweise auch bei Schweißgeräten, Batterieladegeräten, Brennstoffzellen oder dergleichen eingesetzt werden.

## Patentansprüche

1. Verfahren zur Durchführung eines Schaltvorgangs mit Hilfe eines Bedienelements (13), **dadurch gekennzeichnet, dass** als Bedienelement (13) zumindest eine als Anzeige, beispielsweise eines Betriebszustands eines Geräts, vorgesehene Leuchtdiode (14) in einem abgeschalteten Zustand und eine Einrichtung zur Messung der Spannung (15) an der zumindest einen Leuchtdiode (14) verwendet wird, die durch das Umgebungslicht hervorgerufene Spannung (15) an der zumindest einen Leuchtdiode (14) im abgeschalteten Zustand gemessen wird, und der Schaltvorgang durchgeführt wird, wenn infolge einer Abdunkelung der zumindest einen Leuchtdiode (14) durch einen Finger eines Bedieners aufgrund einer Verringerung des Umgebungslichts die gemessene Spannung (15) über eine vorgegebene Zeitdauer (19) unter einen vorgegebenen ersten Schwellwert (18) sinkt.

2. Verfahren nach Anspruch 1, **dadurch gekennzeichnet, dass** der Schaltvorgang durchgeführt wird, wenn zusätzlich die gemessene Spannung (15) nach dem Absinken unter den vorgegebenen ersten Schwellwert (18) über eine definierte Zeitdauer (21) über einen vorgegebenen zweiten, ober dem ersten Schwellwert (18) liegenden Schwellwert (20) steigt.

3. Verfahren nach Anspruch 2, **dadurch gekennzeichnet, dass** der zweite Schwellwert (20) in Abhängigkeit der Stärke des Umgebungslichts geändert wird.

4. Verfahren nach einem der Ansprüche 1 bis 3, **dadurch gekennzeichnet, dass** die zumindest eine Leuchtdiode (14) periodisch abgeschaltet wird, und jeweils mit der Abschaltung die Messung der Spannung (15) an der zumindest einen Leuchtdiode (14) im abgeschalteten Zustand gestartet wird.

5. Verfahren zur Durchführung eines Schaltvorgangs mit Hilfe eines Bedienelements (13), **dadurch gekennzeichnet, dass** als Bedienelement (13) zumindest eine als Anzeige, beispielsweise eines Betriebszustands eines Geräts, vorgesehene Leuchtdiode (14) in einem abgeschalteten Zustand und eine Einrichtung zur Messung der Spannung (15) an der zumindest einen Leuchtdiode (14) verwendet wird, die Spannung (U) an der zumindest einen Leuchtdiode (14) im abgeschalteten Zustand gemessen wird, die zumindest eine Leuchtdiode (14) während des abgeschalteten Zustands mit zumindest einer Referenzleuchtdiode (23) bestrahlt wird, um eine Unabhängigkeit vom Umgebungslicht zu erzielen, die durch das Licht der Referenzleuchtdiode (23) hervorgerufene Spannung (15) an der zumindest einen Leuchtdiode (14) im abgeschalteten und durch die zumindest eine Referenzleuchtdiode (23) bestrahlten Zustand gemessen wird, und danach die zumindest eine Referenzleuchtdiode (23) abgeschaltet wird, die Spannung (15) an der zumindest einen Leuchtdiode (14) im abgeschalteten Zustand der zumindest einen Referenzleuchtdiode (23) gemessen wird, und der Schaltvorgang durchgeführt wird, wenn infolge einer Abdunkelung der zumindest einen Leuchtdiode (14) durch einen Finger eines Bedieners die gemessene Spannung (15) über eine vorgegebene Zeitdauer (31) unter einen vorgegebenen ersten Schwellwert (26) sinkt.

6. Verfahren nach Anspruch 5, **dadurch gekennzeichnet, dass** die zumindest eine Referenzleuchtdiode (23) nach einer definierten Zeitdauer wieder eingeschaltet wird, sodass ein weiterer Schaltvorgang durchgeführt werden kann.

7. Verfahren nach Anspruch 5 oder 6, **dadurch gekennzeichnet, dass** der Schaltvorgang nur dann durchgeführt wird, wenn die gemessene Spannung (15) innerhalb eines zwischen einem zweiten, ober dem ersten Schwellwert (26) liegenden Schwellwert (25) und dem ersten Schwellwert (26) vorgegebenen Auswertebereiches (25-26) liegt.

8. Verfahren nach einem der Ansprüche 1 bis 7, **dadurch gekennzeichnet, dass** die Durchführung des Schaltvorgangs optisch, akustisch oder mechanisch signalisiert wird.

9. Vorrichtung zur Durchführung eines Schaltvorgangs mit einem Bedienelement (13), **dadurch gekennzeichnet, dass** das Bedienelement (13) durch zumindest eine als Anzeige, beispielsweise eines Betriebszustands eines Geräts, vorgesehene Leuchtdiode (14) gebildet ist, eine Einrichtung zur Messung der durch das Umgebungslicht hervorgerufene Spannung (15) an der zumindest einen Leuchtdiode (14) in einem abgeschalteten Zustand vorgesehen ist, sodass der Schaltvorgang durchführbar ist, wenn die gemessene Spannung (15) infolge einer Abdunkelung der zumindest einen Leuchtdiode (14) durch einen Finger eines Bedieners aufgrund einer Verringerung des Umgebungslichts über eine vorgegebene Zeitdauer (19, 31) unter einen vorgegebenen ersten Schwellwert (18, 26) sinkt.

10. Vorrichtung nach Anspruch 9, **dadurch gekennzeichnet, dass** die Einrichtung zur Messung der Spannung (15) durch einen Messverstärker (16) gebildet ist.

11. Vorrichtung nach Anspruch 9 oder 10, **dadurch gekennzeichnet, dass** der zumindest einen Leuchtdiode (14) ein Widerstand (34) parallel geschaltet ist und dass Anschlüsse der zumindest einen Leuchtdiode (14), welche mit der Einrichtung zur Messung der Spannung (15) verbunden sind, über jeweils einen Kondensator (37, 38) mit Erde verbunden sind.

12. Vorrichtung nach einem der Ansprüche 9 bis 11, **dadurch gekennzeichnet, dass** zumindest eine Referenzleuchtdiode (23) zur Erzeugung eines definierten Umgebungslichts vorgesehen ist.

13. Vorrichtung nach einem der Ansprüche 9 bis 12, **dadurch gekennzeichnet, dass** um die zumindest eine Leuchtdiode (14) und allenfalls zumindest eine Referenzleuchtdiode (23) eine teilweise lichtundurchlässige Abdeckung (24) angebracht ist.

## Claims

1. A method for performing a switching operation by the aid of an operating element (13), **characterized in that** at least one light-emitting diode (14) provided as a display, for instance, of an operating state of a device, in a switched-off state, and a device for measuring the voltage (15) on the at least one light-emitting diode (14) are used as said operating element (13), the voltage (15) on the at least one light-emitting diode (14), which is induced by the ambient light, is measured in the switched-off state, and the switching operation is performed if and when the measured voltage (15) falls below a pregiven first threshold (18) for a pregiven time period (19) because of the shading of the at least one light-emitting diode (14) due to a reduction of the ambient light caused by a finger of an operator.

2. The method according to claim 1, **characterized in that** the switching operation is performed if and when the measured voltage (15), after having fallen below the pregiven first threshold (18), additionally rises for a defined time period (21) above a pregiven second threshold (20) lying above the first threshold (18).

3. The method according to claim 2, **characterized in that** the second threshold (20) is changed as a function of the intensity of the ambient light.

4. The method according to any one of claims 1 to 3, **characterized in that** the at least one light-emitting diode (14) is periodically switched off, and upon switching-off the measurement of the voltage (15) on the at least one light-emitting diode (14) is each started in the switched-off state.

5. A method for performing a switching operation by the aid of an operating element (13), **characterized in that** at least one light-emitting diode (14) provided as a display, for instance, of an operating state of a device, in the switched-off state, and a device for measuring the voltage (15) on the at least one light-emitting diode (14) are used as said operating element (13), the voltage (U) on the at least one light-emitting diode (14) is measured in the switched-off state, the at least one light-emitting diode (14) is irradiated by at least one reference light-emitting diode (23) during the switched-off state so as to achieve independence of the ambient light, the voltage (15) on the at least one light-emitting diode (14), which is induced by the light of the reference light-emitting diode (23), is measured in the switched-off state irradiated by the at least one reference light-emitting diode (23) and the at least one reference light-emitting diode (23) is subsequently switched off, the voltage (15) on the at least one light-emitting diode (14) is measured in the switched-off state of said at least one reference light-emitting diode (23), and the switching operation is performed if and when the measured voltage (15) falls below a pregiven first threshold (26) for a pregiven time period (31) because of the shading of the at least one light-emitting diode (14) caused by a finger of an operator.

6. The method according to claim 5, **characterized in that** the at least one reference light-emitting diode (23) is switched on after a defined time period, so that a further switching operation can be performed.

7. The method according to claim 5 or 6, **characterized in that** the switching operation is only performed, if and when the measured voltage (15) lies within a pregiven evaluation range (25-26) between a second threshold (25) lying above the first threshold (26) and the first threshold (26).

8. The method according to any one of claims 1 to 7, **characterized in that** the execution of the switching operation is signaled optically, acoustically or mechanically.

9. A device for performing a switching operation by the aid of an operating element (13), **characterized in that** the operating element (13) is formed by at least one light-emitting diode (14) provided as a display, for instance, of an operating state of a device, a device for measuring the voltage (15) on the at least one light-emitting diode (14), which is induced by the ambient light, in a switched-off state is provided to enable the switching operation if and when the measured voltage (15) falls below a pregiven first threshold (18, 26) for a pregiven time period (19, 31) because of the shading of the at least one light-emitting diode (14) due to a reduction of the ambient light caused by a finger of an operator.

10. The device according to claim 9, **characterized in that** the device for measuring the voltage (15) is formed by a measuring amplifier (16).

11. The device according to claim 9 or 10, **characterized in that** a resistor (34) is connected in parallel with the at least one light-emitting diode (14), and that connections of the at least one light-emitting diode (14), which are connected to the device for measuring the voltage (15), are each connected to ground via a capacitor (37, 38).

12. The device according to any one of claims 9 to 11, **characterized in that** at least one reference light-emitting diode (23) is provided to create a defined ambient light.

13. The device according to any one of claims 9 to 12, **characterized in that** a partially opaque cover (24) is arranged around the at least one light-emitting diode (14) and optionally the at least one reference light-emitting diode (23).

## Revendications

1. Procédé de réalisation d'un processus de commutation à l'aide d'un élément de commande (13), **caractérisé en ce que**, en tant qu'élément de commande (13), il est utilisé au moins une diode électroluminescente (14) prévue en tant qu'indication, par exemple d'un état de fonctionnement d'un appareil, dans un état débranché et un dispositif de mesure de la tension (15) sur l'au moins une diode électroluminescente (14), la tension (15) suscitée par la lumière ambiante est mesurée sur l'au moins une diode électroluminescente (14) dans l'état débranché, et le processus de commutation est réalisé si, par suite d'un obscurcissement de l'au moins une diode électroluminescente (14) par un doigt d'un opérateur, la tension (15) mesurée passe, en raison d'une diminution de la lumière ambiante, sous une première valeur seuil (18) prédéfinie pendant une durée (19) prédéfinie.

2. Procédé selon la revendication 1, **caractérisé en ce que** le processus de commutation est réalisé si en plus la tension (15) mesurée, après le passage sous la première valeur seuil (18) prédéfinie, passe pendant une durée définie (21) au-dessus d'une deuxième valeur seuil (20) prédéfinie supérieure à la première valeur seuil (18).

3. Procédé selon la revendication 2, **caractérisé en ce que** la deuxième valeur seuil (20) est modifiée en fonction de l'intensité de la lumière ambiante.

4. Procédé selon l'une quelconque des revendications 1 à 3, **caractérisé en ce que** l'au moins une diode électroluminescente (14) est débranchée périodiquement, et **en ce que**, respectivement avec le débranchement, la mesure de la tension (15) est lancée sur l'au moins une diode électroluminescente (14) dans l'état débranché.

5. Procédé de réalisation d'un processus de commutation à l'aide d'un élément de commande (13), **caractérisé en ce que**, en tant qu'élément de commande (13), il est utilisé au moins une diode électroluminescente (14) prévue en tant qu'indication, par exemple d'un état de fonctionnement d'un appareil, dans un état débranché et un dispositif de mesure de la tension (15) sur l'au moins une diode électroluminescente (14), la tension (U) est mesurée sur l'au moins une diode électroluminescente (14) dans l'état débranché, l'au moins une diode électroluminescente (14) est éclairée, pendant l'état débranché, par au moins une diode électroluminescente de référence (23) pour obtenir une indépendance vis-à-vis de la lumière ambiante, la tension (15) suscitée par la lumière de la diode électroluminescente de référence (23) est mesurée sur l'au moins une diode électroluminescente (14) dans l'état débranché et dans l'état éclairé par l'au moins une diode électroluminescente de référence (23), et ensuite l'au moins une diode électroluminescente de référence (23) est débranchée, la tension (15) sur l'au moins une diode électroluminescente (14) est mesurée dans l'état débranché de l'au moins une diode électroluminescente de référence (23), et le processus de commutation est réalisé si, par suite d'un obscurcissement de l'au moins une diode électroluminescente (14) par un doigt d'un opérateur, la tension (15) mesurée passe sous une première valeur seuil (26) prédéfinie pendant une durée (31) prédéfinie.

6. Procédé selon la revendication 5, **caractérisé en ce que** l'au moins une diode électroluminescente de référence (23) est rebranchée après une durée définie, de sorte qu'un autre processus de commutation peut être réalisé.

7. Procédé selon la revendication 5 ou 6, **caractérisé en ce que** le processus de commutation ne peut être réalisé que si la tension (15) mesurée se situe à l'intérieur d'une plage d'évaluation (25-26) prédéfinie entre une deuxième valeur seuil (25) supérieure à de la première valeur seuil (26) et la première valeur seuil (26).

8. Procédé selon l'une quelconque des revendications 1 à 7, **caractérisé en ce que** la réalisation du processus de commutation est signalée de manière optique, acoustique ou mécanique.

9. Dispositif de réalisation d'un processus de commutation avec un élément de commande (13), **caractérisé en ce que** l'élément de commande (13) est formé par au moins une diode électroluminescente (14) prévue en tant qu'indication, par exemple d'un état de fonctionnement d'un appareil, **en ce qu'**il est prévu un dispositif de mesure de la tension (15) suscitée par la lumière ambiante sur l'au moins une diode électroluminescente (14) dans un état débranché, de sorte que le processus de commutation peut être réalisé si, par suite d'un obscurcissement de l'au moins une diode électroluminescente (14) par un doigt d'un opérateur, la tension (15) mesurée passe, en raison de la diminution de la lumière ambiante, sous une première valeur seuil (18, 26) prédéfinie pendant une durée (19, 31) prédéfinie.

10. Dispositif selon la revendication 9, **caractérisé en ce que** le dispositif de mesure de la tension (15) est formé par un amplificateur de mesure (16).

11. Dispositif selon la revendication 9 ou 10, **caractérisé en ce qu'**une résistance (34) est branchée en parallèle avec l'au moins une diode électroluminescente (14), et **en ce que** les bornes de l'au moins une diode électroluminescente (14), qui sont raccordées au dispositif de mesure de la tension (15) sont raccordées à la terre par le biais de respectivement un condensateur (37, 38).

12. Dispositif selon une des revendications 9 à 11, **caractérisé en ce qu'**il est prévu au moins une diode électroluminescente de référence (23) pour la production d'une lumière ambiante définie.

13. Dispositif selon l'une quelconque des revendications 9 à 12, **caractérisé en ce qu'**un recouvrement (24) partiellement opaque est mis en place autour de l'au moins une diode électroluminescente (14) et éventuellement autour de l'au moins une diode électroluminescente de référence (23).
